# EUROPEAN PATENT APPLICATION

(11) **EP 4 800 482 A1**
(43) Date of publication of application: **02.09.2026**
(21) Application number: 25160653.9
(22) Date of filing: 27.02.2025
(51) Int. Cl.: G03F 7/20, H01L 21/687

(54) **A SUBSTRATE SUPPORT ASSEMBLY, EXPOSURE APPARTUS COMPRISING A SUBSTRATE SUPPORT ASSEMBLY, AND METHOD**

(71) Applicant: ASML Netherlands B.V., 5500 AH Veldhoven (NL)
(72) Inventor: HUANG, Yang-Shan, 5500 AH Veldhoven (NL); SMEETS, Benjamin, Cunnegonda, Henricus, 5500 AH Veldhoven (NL); BECKERS, Johan, Franciscus, Maria, 5500 AH Veldhoven (NL)
(74) Representative: ASML Netherlands B.V.

(57) **Abstract**

The invention provides a substrate support assembly configured to support a substrate, the substrate support assembly comprising:
a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
a support configured to clamp the substrate to the support table, wherein the support table is held within a recess provided in the support, the plurality of bottom burls facing a base of the recess,
an actuator assembly comprising one or more actuators arranged in the recess and configured to move the support table relative to the support in a transverse direction with respect to the support plane.

## Description

### FIELD

The present invention relates to a substrate support assembly to support a substrate, an exposure apparatus comprising a substrate support assembly, and a method for supporting a substrate. The substrate is for instance a wafer.

### BACKGROUND

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect particles or measure a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask, a reticle) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In existing semiconductor manufacturing systems, substrate tables struggle to accommodate variations in wafer thickness, particularly in immersion lithography systems where the immersion hood operates at a controlled fly height. If the fly height remains unchanged when processing thicker wafers, there is a risk that the immersion hood may collide with the wafer surface. Conversely, if the fly height is increased to prevent contact, an excessive amount of liquid may be left behind on the wafer surface and/or the substrate table. These residual droplets can cause printing defects, misalignment errors in sensors, and overall degradation of pattern accuracy, negatively impacting the manufacturing yield and process reliability.

Therefore, there is a need for an improved substrate support assembly that can effectively support wafers of varying thickness while maintaining optimal immersion conditions. The present disclosure aims to provide such an improved solution or, at the very least, an alternative substrate support assembly that mitigates the aforementioned drawbacks.

### SUMMARY

According to an aspect of the invention there is provided a substrate support assembly comprising:
a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
a support configured to clamp the substrate to the support table, wherein the support table is held within a recess provided in the support, the plurality of bottom burls facing a base of the recess,
an actuator assembly comprising one or more actuators arranged in the recess and configured to move the support table relative to the support in a transverse direction with respect to the support plane.

In an embodiment, the base of the recess comprises holes for at least partially accommodating the plurality of bottom burls.

In an embodiment, the one or more actuators are located between the bottom surface of the support table and the base of the recess.

In an embodiment, the one or more actuators are located near or at an edge of the support table.

In an embodiment, the support is configured to generate a vacuum or an electrostatic clamping force to clamp the substrate to the support table.

In an embodiment, the support comprises a low melting point metal and a heat source, wherein the heat source is configured to melt the low melting point metal by supplying heat to fill a gap between the recess and the support table with melted low melting point metal, and to solidify the melted low melting point metal by removing heat to clamp the substrate to the support table.

In an embodiment, the one or more actuators are being
located in between the plurality of bottom burls, and wherein the support comprises a plurality of clamp burls arranged at the base of the recess, and wherein each actuator is configured to grip an associated clamp burl and/or to slide along the associated clamp burl, or
at least partially arranged in the holes of the base of the recess, wherein each actuator is configured to grip an associated bottom burl and/or to slide along the associated bottom burl,
to move the support table relative to the support in a transverse direction with respect to the support plane.

In an embodiment, the substrate support assembly further comprises a vacuum seal arranged at or near an edge of the support table for enabling vacuum in a space between the bottom surface of the support table and the base of the recess.

In an embodiment, the actuator assembly comprises one or more piezoelectric actuators, for example one or more inchworm motors or one or more piezo-driven screws.

In an embodiment, substrate support assembly further comprises:
a measurement system to determine a distance between the support table and the base of the recess, the measurement system being configured to provide a measurment signal representative of the determined distance,
a controller configured to receive the measurement signal and to control the one or more actuators based on the received measurement signal.

According to an aspect of the invention, there is provided a substrate support assembly configured to support a substrate, the substrate support assembly comprising:
a support table configured to support the substrate in a support plane,
a support configured to clamp the substrate to the support table, wherein the support table is held within a recess provided in the support
a rotatable pot hole body facing a base of the recess, the pot hole body comprising outer threads engaging recess threads provided at a wall of the recess,
an actuator assembly comprising one or more actuators arranged in the recess, wherein the actuator assembly is configured to rotate the pot hole body relative to the recess to move the support table relative to the support in a transverse direction with respect to the support plane.

In an embodiment, the pot hole body is part of the support table.

In an embodiment, the actuator assembly comprises one or more spring pre-loaded actuators, for example one or more piezoelectric actuators such as one or more inchworm motors.

In an embodiment, the support comprises a rotatable feedthrough provided in the base of the recess, the feedthrough comprising one or more channels.

According to an aspect of the invention, there is provided a substrate support assembly configured to support a substrate, the substrate support assembly comprising:
a support table configured to support the substrate in a support plane,
a support configured to clamp the substrate to the support table, wherein the support table is held within a recess in the support, the support having a moveable top plate being movable relative to a base of the recess,
an actuator assembly comprising one or more actuators arranged at the support and configured to move the top plate relative to the base of the recess in a transverse direction with respect to the support plane.

In an embodiment, the actuator assembly comprises one or more linear actuators.

In an embodiment, the actuator assembly comprises one or more leaf springs or one or more linear bearings configured to guide the movement of the top plate relative to the base of the recess.

In an embodiment, the top plate is optically transparent to a wavelength of about 193nm.

In an embodiment, the substrate support assembly further comprises a measurement system configured to determine the position of the top plate relative to the support table.

In an embodiment, the support table supports a backside of the substrate, wherein a topside of the substrate is opposite to the backside, wherein the actuator assembly is configured to arrange the topside of the substrate below a top surface of the support or the topside of the substrate flush with the top surface of the support.

In an embodiment, a circumferential spacer ring is arranged at or near an edge of the support table in the support plane, or between the support table and wall of the recess.

According to an aspect of the invention, there is provided a method for supporting a substrate, the method comprising the steps of:
providing a substrate support assembly comprising:
   a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
   a support configured to clamp the substrate to the support table, wherein the support table is held within a recess provided in the support, the plurality of bottom burls facing a base of the recess,
moving the support table relative to the support in a transverse direction with respect to the support plane.

According to an aspect of the invention, there is provided a method for supporting a substrate, the method comprising the steps of:
providing a substrate support assembly comprising:
   a support table configured to support the substrate in a support plane,
   a support configured to clamp the substrate to the support table, wherein the support table is held within a recess provided in the support,
   a rotatable pot hole body facing a base of the recess, the pot hole body comprising outer threads engaging recess threads provided at a wall of the recess,
rotating the pot hole body relative to the recess to move the support table relative to the support in a transverse direction with respect to the support plane.

According to an aspect of the invention, there is provided a method for supporting a substrate, the method comprising the steps of:
providing a substrate support assembly comprising:
   a support table configured to support the substrate in a support plane,
   a support configured to clamp the substrate to the support table, wherein the support table is held within a recess in the support, the support having a moveable top plate being movable relative to a base of the recess,
moving the top plate relative to the base of the recess in a transverse direction with respect to the support plane.

According to an aspect of the invention, there is provided an exposure apparatus comprising a substrate support assembly of the invention.

Further features of the disclosure, as well as the structure and operation of various embodiments of the disclosure, are described in detail below with reference to the accompanying drawings. It is noted that the disclosure is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

The accompanying drawings, which are incorporated herein and form part of the specification, illustrate the present disclosure and, together with the description, further serve to explain the principles of the disclosure and to enable a person skilled in the relevant art(s) to make and use the disclosure. Embodiments of the present disclosure will now be described, by way of example only, with reference to the accompanying schematic drawings, in which:
Figure 1 depicts a schematic overview of an exposure apparatus, such as a lithographic apparatus, according to an embodiment of the invention;
Figure 2 depicts a detailed view of a part of the exposure apparatus of Figure 1;
Figure 3 schematically depicts a position control system as part of a positioning system according to an embodiment of the invention;
Figure 4 shows a side view of a schematic illustration of a first embodiment of a substrate support assembly supporting a standard substrate;
Figure 5 shows a side view of a schematic illustration of the substrate support assembly of Figure 4, the substrate assembly supporting a thicker substrate;
Figure 6 shows a side view of a schematic illustration of a second embodiment of a substrate support assembly supporting a standard substrate;
Figure 7 shows a side view of a schematic illustration of the substrate support assembly of Figure 6, the substrate assembly supporting a thicker substrate;
Figure 8 shows a side view of a schematic illustration of a third embodiment of a substrate support assembly, the substrate support assembly supporting a substrate;
Figure 9 shows a side view of a schematic illustration of a fourth embodiment of a substrate support assembly, the substrate support assembly supporting a substrate;
Figure 10 shows a side view of a schematic illustration of a fifth embodiment of a substrate support assembly, the substrate support assembly supporting a substrate.

The features of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. Additionally, generally, the leftmost digit(s) of a reference number identifies the drawing in which the reference number first appears. Unless otherwise indicated, the drawings provided throughout the disclosure should not be interpreted as to-scale drawings.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

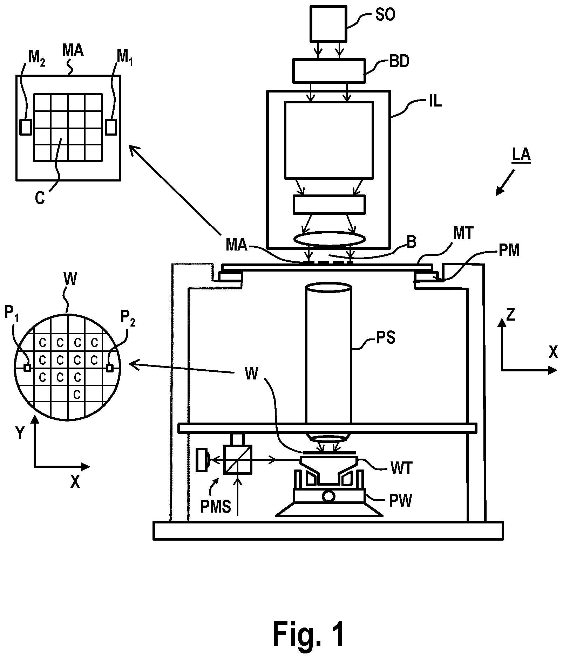

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a support table or a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

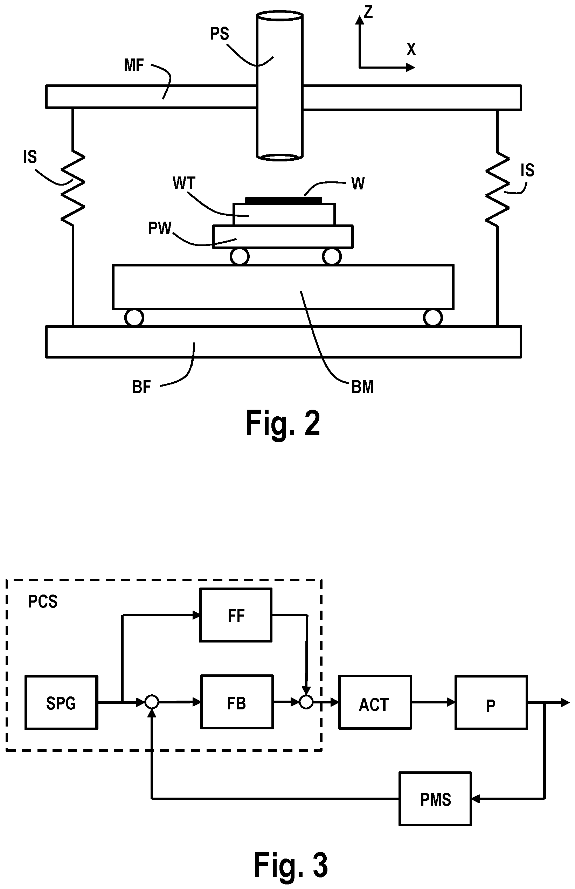

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SPG, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SPG generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

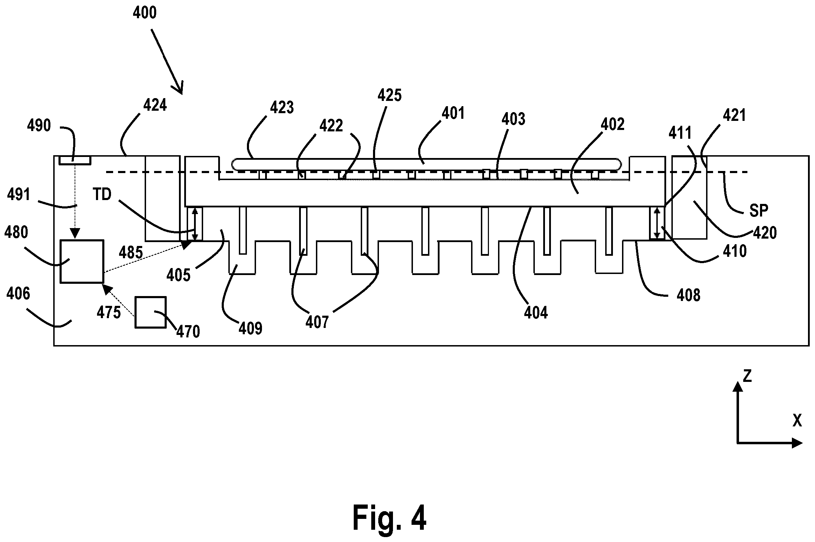

Figures 4-5 show a side view of a schematic illustration of a first embodiment of a substrate support assembly 400. The substrate support assembly 400 supports a substrate 401, such as a wafer, during lithographic processing. The substrate support assembly 400 comprises a support table 402, also referred to as a wafer table, configured to support the substrate 401 in a support plane SP (indicated by the dotted line). The support plane SP extends in the xy plane. The support table 402 has a top surface 403 facing the substrate 401 and a bottom surface 404 opposite to the top surface 403. The support plane SP is parallel to the top surface 403 of the support table 402.

The support table 402 is held within a recess 405 provided in a support 406, also referred to as a chuck. The support 406 is configured to clamp the substrate 401 to the support table 402, thereby securing the substrate 401 during substrate operations such as exposure. Clamping may be achieved using vacuum, electrostatic forces, or another suitable clamping mechanism. The bottom surface 404 of the support table 402 comprises a plurality of bottom burls 407, which are positioned to face a base 408 of the recess 405. The plurality of bottom burls 407 are distributed across the bottom surface 404. The bottom burls 407 may function as mechanical spacers, defining a controlled gap between the support table 402 and the base 408 of the recess 405. This gap may facilitate thermal management, mitigate stress-induced deformations, and allow for controlled movement or adjustment of the support table 402 relative to the support 406. The support 406 provide controlled spacing and mechanical support between the support table 402 and the base 408 of the recess 405, ensuring stable and precise positioning of the support table 402 within the support 406. Further, a plurality of upper burls 422 are provided at the top surface 403 of the support table 402, the upper burls 422 having distal ends 425 positioned in the support plane SP. These upper burls 422 supports the wafer 401 by making contact with the underside of the wafer 401. The upper burls 422 may be designed with specific surface characteristics, such as a tapered or rounded shape, to further improve the contact between the wafer 401 and the support table 402, ensuring minimal contact area and reducing friction during wafer handling.

The embodiment of Figures 4-5 shows that the base 408 of the recess 405 comprises a plurality of holes 409. Each hole 409 is configured to at least partially accommodate a corresponding bottom burl 407. Each hole 409 may be provided with a low melting point metal. The low melting point metal may include, for example, indium, gallium-based alloys, or bismuth-based alloys. A heat source, e.g. comprising one or more heating coils, may be provided on the support table or on the support. In an alternative embodiment, the substrate support assembly comprises an external induction heat source configured to selectively heat the low melting point metal provided in the holes at the base of the recess. The external induction heat source is positioned outside the stage and can be activated when needed to induce localized heating in the low melting point metal. The external induction heat source can be implemented as a tooling component or as an integrated part of the exposure apparatus, providing increased system flexibility. By positioning the heat source externally, the complexity of the substrate support assembly is reduced, as no embedded heating elements or internal wiring are required. This configuration also enhances backward compatibility.

When heat is applied via the heat source, the low melting point metal melts and reflows, filling the gap between the support 406 and the bottom burls 407. This molten state allows the support table 402 to move relative to the support 406, enabling fine adjustments or repositioning in the z-direction. Upon removal of the heat, the low melting point metal solidifies, mechanically fixing the bottom burls 407 in place within the holes 409. This provides structural support in the z-direction, securing the support table 402 at a defined height within the recess 405. Additionally, upon solidification of the low melting point metal, the support table 402 is also fixed in the xy-direction, thereby restricting lateral displacement relative to the support 406. The transition between solid and liquid states enables a clamping mechanism that can be selectively activated or released, allowing controlled movement of the support table 402.

In some embodiments, localized heating of selected holes 409 may allow for partial release of the clamping mechanism, facilitating tilt correction or fine leveling adjustments of the support table 402. Additionally, the low melting point metal may be selected to have high thermal conductivity to ensure rapid phase transitions and minimal thermal lag during operation.

Alternatively, the adjusting mechanism provides only temporary support during the z-direction adjustment of the support table 402. After the adjustment process is completed, the adjusting mechanism can be retracted, ensuring that it does not bear any load during normal operation. The adjusting mechanism may be implemented using a miniature leadscrew, an inertial slider, or other precision positioning components capable of providing controlled displacement in the z-direction. These mechanisms allow for fine positional adjustments of the support table 402 before the primary clamping mechanism, such as the low melting point metal and heat source, secures the support table 402 in place. The targeted motion range of the adjusting mechanism is, for example, about 1 mm, enabling compensation for wafer thickness variations or leveling corrections. The retractability of the adjusting mechanism ensures that once the support table 402 is fixed at the desired position, the assembly 400 remains free of any residual mechanical influences from the adjustment process, thereby minimizing potential disturbances to wafer stability. To further enhance positional accuracy and ensure stability, additional measures can be implemented to compensate for the gravitational sag of the support table 402. During the adjustment process, one or more level sensors can be used to detect the actual position and orientation of the support table 402 relative to the desired specification (see also in this regard the fifth embodiment). These level sensors provide feedback on deviations, allowing the substrate support assembly 400 to perform iterative adjustments if necessary. If the detected position does not meet the required specifications, one or more additional adjustment cycles can be executed, refining the position until the support table 402 reaches the target position and/or shape.

To enable different types of wafer thicknesses, an actuator assembly 410 is arranged in the recess 405. The actuator assembly 410 comprises an actuator 410 configured to move the support table 402 relative to the support 406 in a transverse direction TD, i.e. the z-direction, with respect to the support plane SP. The actuator 410 may function in coordination with the one or more heating coils and low melting point metal to temporarily reposition the support table 402 when the clamping mechanism is released.

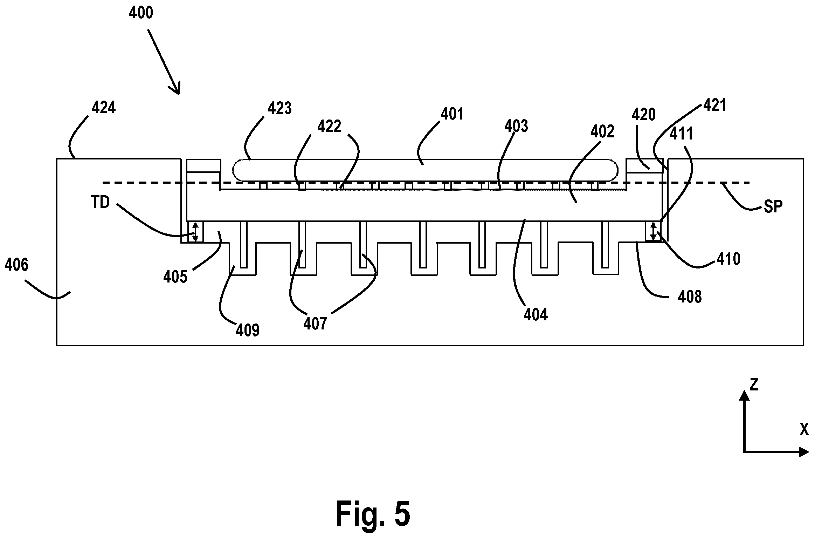

In Figure 4, a standard wafer, e.g. having a standard thickness of approximately 775 µm, is supported by the substrate support assembly 400, while in Figure 5, a thick wafer, having a thickness of, for example, 1 mm or greater, is supported by the substrate support assembly 400. To transition from supporting a standard wafer (Figure 4) to a thick wafer (Figure 5), the actuator assembly 410 adjusts the position of the support table 402 in the transverse direction TD, bringing the support table 402 closer towards the base 408 of the recess 405. By dynamically adjusting the position of the support table 402, the substrate support assembly 400 is able to accommodate wafers of varying thicknesses while maintaining optimal conditions, such as for immersion lithographic processing. Additionally, the ability to adjust for wafer thickness ensures that the immersion fluid used in the lithographic process remains properly confined, preventing disturbances in fluid dynamics that could otherwise affect imaging performance. By compensating for thickness variations, the substrate support assembly 400 also minimizes any potential impact on thermal stability, wafer handling forces, or structural integrity of the substrate support assembly.

In the embodiment of Figures 4-5, the actuator 410 is located near an edge 411 of the support table 402, and between the bottom surface 404 of the support table 402 and the base 408 of the recess 405 in the support 406. The actuator assembly 410 may include, for example, piezoelectric actuators, pneumatic actuators, electromagnetic actuators.

The actuator 410 is configured to adjust the position of the support table 402 so that the topside 423 of the substrate 401 is arranged below a top surface 424 of the support 406 or so that the topside 423 of the substrate 401 is flush with the top surface 424 of the support 406. In the first configuration, where the topside 423 of the substrate 401 is arranged below the top surface 424 of the support 406, the actuator 410 lowers the support table 402 in the transverse direction TD to create a slight recess relative to the surrounding support surface. In the second configuration, where the topside of the substrate 401 is flush with the top surface 424 of the support 406, the actuator 410 brings the wafer 401 into a level alignment with the support 406.

In some embodiments, the actuator 410 may also enable tilt correction by selectively adjusting different regions of the support table 402. This allows for compensation of mechanical tolerances, thermal expansion effects, or other deviations in the support structure. Once the support table 402 is positioned at the desired z-height, the actuator 410 may be deactivated, and the clamping mechanism can be engaged to fix the support table 402 in place.

The substrate support assembly 400 further comprises a measurement system 470, which is configured to determine a distance between the support table 402 and the base 408 of the recess 405. In one example, this determination is performed via said one or more level sensors. The measurement system 470 is further configured to generate a measurement signal 475 representative of the determined distance. The substrate support assembly 400 additionally comprises a controller 480 configured to receive the measurement signal 475 and control the actuator system 410 based on the received signal 475. The controller 480 generates and transmits a corresponding control signal 485 to the actuator 410 to adjust the position of the support table 402 relative to the base 408 of the recess 405. In the illustrated embodiment, the controller 480 is supplied with electrical power 491 via an electrical contact pad 490 arranged at the top surface 424 of the support 406. In an alternative implementation, the controller 480 and associated cabling, such as the electrical contact pad 490, may be provided as an external tooling system. In such a configuration, the external tooling can be temporarily connected to perform the required adjustment of the support table 402. Once the adjustment process is completed, the external tooling system can be removed, thereby reducing system complexity.

In some embodiments, the substrate support assembly 400 may be provided with a circumferential spacer ring 420, which might in an embodiment be referred to as a Bubble Extraction System (BES) ring. The circumferential spacer ring 420 is positioned around the periphery of the support table 402 and is configured to control fluid dynamics in immersion lithography processes, for example, to reduce outflow of fluid escaping from a space between the support table 402 and the support 406. The circumferential spacer ring 420 serves multiple functions. One primary function is to facilitate the removal of gas bubbles from the immersion fluid surrounding the wafer 401. During immersion lithography, a thin layer of immersion fluid is maintained between the projection optics and the wafer 401 to enhance imaging resolution. However, unwanted air pockets or bubbles can form at the wafer's edge due to fluid flow dynamics, wafer replacement, or thermal effects. The circumferential spacer ring 420 helps to manage this by creating a controlled flow path that directs trapped bubbles away from the exposure area.

In Figure 4, the circumferential spacer ring 420 is arranged between the support table 402 and the wall 421 of the recess 405 in the support 406. In this configuration, the circumferential spacer ring 420 acts as an intermediate element between the support table 402 and the support 406, providing additional structural stability. Additionally, this placement may influence fluid dynamics around the support table 402, controlling how immersion fluid interacts with the surrounding surfaces. In Figure 5, the circumferential spacer ring 420 is arranged at or near the edge of the support table 402 in the support plane SP. In this configuration, the circumferential spacer ring 420 forms a boundary around the wafer 401, aiding in bubble extraction and stabilizing the immersion fluid during lithographic exposure.

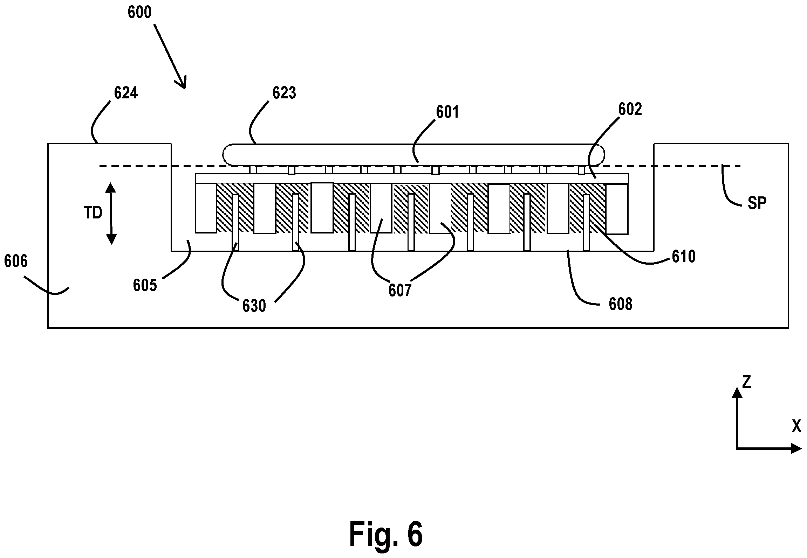

Figures 6-7 show a side view of a schematic illustration of a second embodiment of a substrate support assembly 600. In the embodiment of Figures 6-7, the substrate support assembly 600 includes a modified structure for adjusting the position of the support table 602, which supports the substrate 601. The features of the substrate support assembly 400 of the first embodiment are also applicable the second embodiment, such as the circumferential spacer ring, except for the following difference, which will now be described.

Instead of the holes, the support 606 comprises a plurality of clamp burls 630 arranged at the base 608 of the recess 605. The plurality of clamp burls 630 are arranged in a distributed pattern across the base 608 of the recess 605. Each actuator 610 is configured to grip an associated clamp burl 630 and/or to slide along the associated clamp burl 630, allowing for precise control over the movement of the support table 602 relative to the support 606 in the transverse direction TD (i.e. z-direction) with respect to the support plane SP. The actuator assembly 610 (indicated by the dashed regions) is located between the plurality of bottom burls 607, which are arranged at the bottom surface of the support table 602. By gripping and sliding along the clamp burls 630, each actuator 610 is able of adjusting the position of the support table 602 in the transverse direction TD. In an embodiment, the actuator assembly 610 comprises for example 50 - 150 actuators.

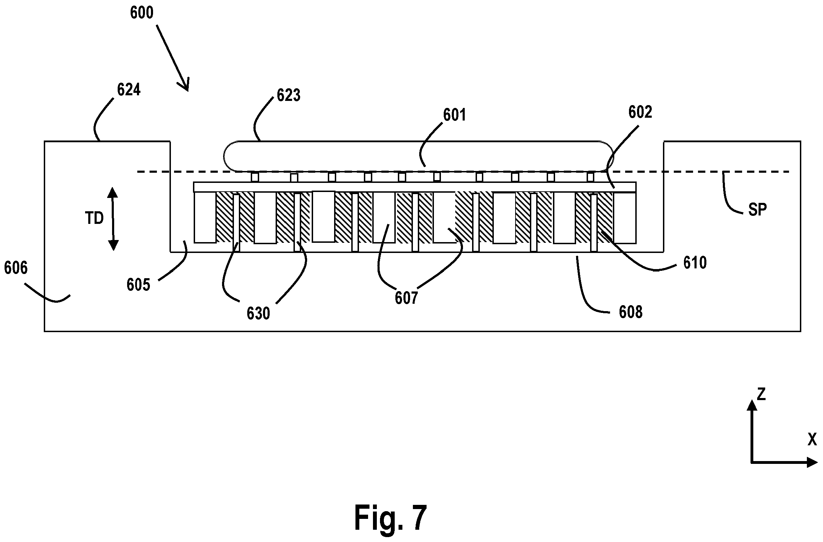

In Figure 6, the substrate support assembly 600 supports a wafer 601, with the support table 602 positioned at a height that aligns the wafer 601 in the optimal exposure position. In this configuration, the actuators 610 adjust the position of the support table 602 ensuring that the topside 623 of the wafer 601 is either below or flush with the top surface 624 of the support 606, which is advantageous for immersion conditions. When transitioning to a thicker wafer, as shown in Figure 7, the actuators 610 adjust the position of the support table 602 to accommodate the increased thickness of the substrate 601. The actuators 610 move the support table 602 in the transvere direction TD relative to the base 608 of the recess 605, by lowering the support table 602 to align the topside 623 of the thicker wafer 601 flush with the top surface 624 of the support 606.

This adjustment may be achieved by fine-tuning the positioning of the support table 602 using one or more piezoelectric actuators 610, such as inchworm motors or piezo-driven screws. These actuators grip or slide along the clamp burls 630 arranged at the base 608 of the recess 605, allowing for precise movement of the support table 602 in very small increments. These piezoelectric actuators 610 are configured to interact with the clamp burls 630 by either gripping or sliding along them. In the case of inchworm motors, these actuators utilize a stepping motion that allows for fine positional control over the support table 602.

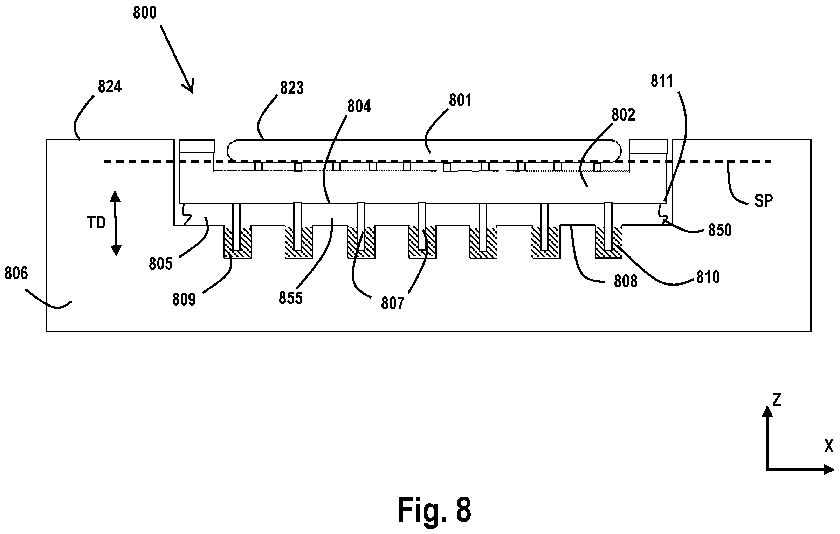

Alternatively, as shown in Figure 8, a third embodiment of a substrate support assembly 800 is provided. In this embodiment, the actuator assembly 810 (indicated by the dashed regions) is at least partially arranged within the holes 809 located in the base 808 of the recess 805. Each actuator 810 is configured to grip an associated bottom burl 807 and/or to slide along the associated bottom burl 807 to move the support table 802 relative to the support 806 in the transverse direction with respect to the support plane SP.

The actuators 810 may include one or more piezoelectric actuators, such as inchworm motors or piezo-driven screws. During operation, the actuators 810 engage with the bottom burls 807. By gripping and/or sliding along the bottom burls 807, the actuators 810 can incrementally raise or lower the support table 802 to accommodate varying substrate thicknesses while ensuring that the topside 823 of the substrate 801 is positioned correctly for optimal processing, e.g. flush with the top surface 824 of the support 806.

Like the embodiment illustrated in Figure 5, a circumferential spacer ring 820 is arranged at or near the edge of the support table 802 in the support plane SP. The substrate support assembly 800 further comprises a vacuum seal 850 arranged near the edge 811 of the support table 802. The vacuum seal 850 is configured to enable the creation of a vacuum in the space 855 between the bottom surface 804 of the support table 802 and the base 808 of the recess 805. By evacuating this space 855, the vacuum seal 850 enhances the clamping force between the support table 802 and the support 806. This vacuum-based clamping mechanism provides an additional force that complements other clamping elements, such as the actuators 810 and the engagement of the bottom burls 807 with the base 808.

In some implementations, the vacuum seal 850 may be a continuous ring-shaped seal extending circumferentially around the support table 802 to ensure uniform sealing and consistent vacuum retention. Alternatively, multiple discrete sealing elements may be distributed along the periphery of the support table 802 to achieve a similar effect while allowing for controlled venting or selective vacuum release when adjustment of the support table 802 is required.

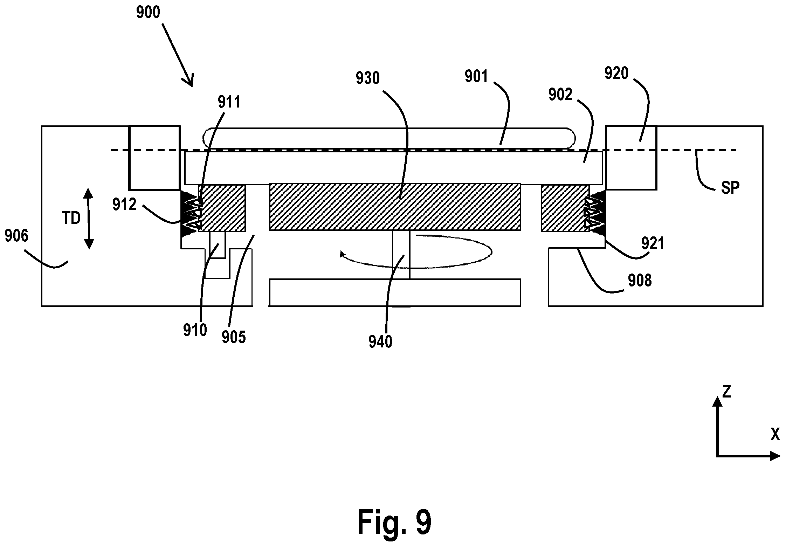

Figure 9 shows a side view of a schematic illustration of a fourth embodiment of a substrate support assembly 900. In the embodiment of Figure 9, the substrate support assembly 900 includes a modified structure for adjusting the position of the support table 902, which supports the substrate 901. The features of the first, second and/or third embodiment also applicable to the fourth embodiment, such as the circumferential spacer ring, except for the following difference, which will now be described.

In Figure 9, the substrate support assembly 900 comprises a rotatable pot hole body 930 (indicated by the dashed region) facing the base 908 of the recess 905. The pot hole body 930 is provided with outer threads 911 that engage with corresponding recess threads 912 provided at the wall 921 of the recess 905. The pot hole body 930 is designed as a moving component that, when rotated, translates its rotational motion into vertical displacement due to the threaded engagement with the recess wall 921. The actuator assembly 910, for example comprising a preloaded small spring actuator, is arranged at the base 908 of the recess 905. Alternatively, the actuator assembly 910 can be implemented as a rotary wheel driven by a rotary motor or as a piezo walking motor. The actuator assembly 910 is configured to rotate the pot hole body 930 relative to the recess 905 to move the support table 902 relative to the support 906 in the transverse direction TD with respect to the support plane SP.

To enable precise control of the support table 902, the substrate support assembly 900 includes a rotary feedthrough 940 with multiple channels, allowing for accurate transmission of motion and control signals. The movement of the support table 902 is configured to translate into discrete rotational increments, ensuring that movement is synchronized with alignment features such as elevator pins, commonly referred to as E-pins, which project through holes in the support table 902. When the substrate 901 is to be loaded, the E-pins extend through the holes in the support table 902 to receive the substrate 901, which is carried by a substrate handler (not shown). The E-pins position the substrate 901 at a controlled distance above the support table 902, allowing the substrate handler to withdraw without disturbing the substrate's alignment. Once the substrate handler is fully retracted, the E-pins are retracted, lowering the substrate 901 onto the support table 902 for secure placement. After exposure, the E-pins extend again to lift the substrate 901 from the support table 902, allowing the substrate handler to pick up and remove the substrate 901. The rotation of the pot hole body 930 is controlled such that the vertical movement occurs in increments of either full rotations or 120-degree steps, ensuring precise alignment with the E-pin mechanism for repeatable and accurate substrate handling.

In an alternative configuration, the pot hole body 930 can be part of the support table 902 such that the pot hole body 930 and the support table 902 are integrated into a single structure. This integration offers multiple advantages, including a reduction of independent parts, such as the number of required channels, which simplifies the control architecture and an increase in the overall stiffness of the support table 902.

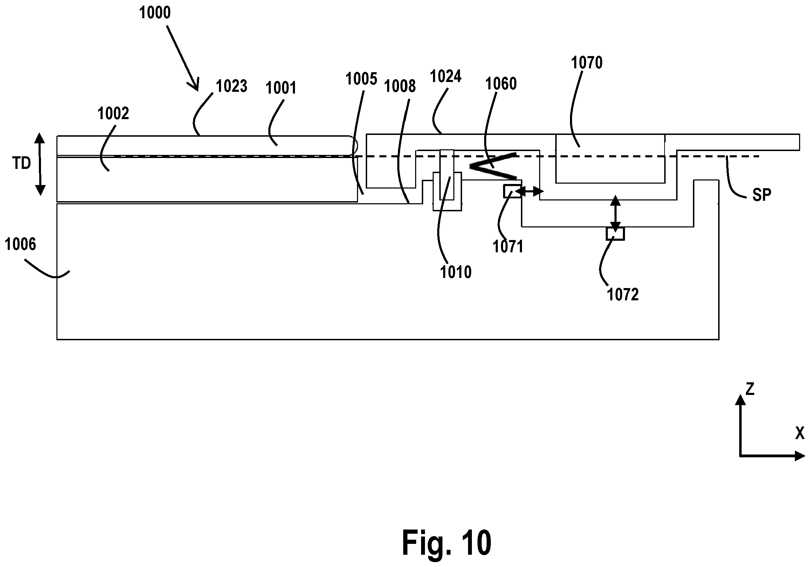

Figure 10 shows a side view of a schematic illustration of a fifth embodiment of a substrate support assembly 1000. In the embodiment of Figure 10, the substrate support assembly 1000 includes a modified structure for adjusting a top plate of the support 1006 relative to the support table 1002, which supports the substrate 1001. The features of the first, second, third and/or fourth embodiment are also applicable to the fifth embodiment, such as the circumferential spacer ring, except for the following difference, which will now be described.

In Figure 10, the substrate support assembly 1000 comprises a support 1006 having a movable top plate 1024, which defines the top surface of the support 1006. The top plate 1024 is movable relative to a base 1008 of the recess 1005 along the transverse direction TD (z-axis) to facilitate precise positioning at or between a low position and a high position, depending on the wafer thickness of the wafer 1001. The movement of the top plate 1024 is controlled by the actuator assembly 1010 arranged at the support 1006.

To ensure that the topside 1023 of the wafer 1001 remains below or flush with the top surface of the support 1006, a linear actuator 1010 is provided to move the top plate 1024 relative to the base 1008 of the recess 1005 in the transverse direction TD with respect to the support plane SP. The movement of the top plate 1024 is guided by a leaf spring mechanism 1060, which functions as a linear guide, restricting motion in the transverse direction TD while maintaining high stiffness and minimal mechanical play.

A measurement system 1070 is integrated into the moveable top plate 1024 to determine the position of the top plate 1024 relative to the support table 1002. The measurement system 1070 is able to track and maintain precise alignment between the wafer 1001 and the support 1006, providing real-time feedback for both lateral and height control. The measurement system 1070 for example includes a lateral sensor 1071, ensuring accurate lateral positioning by detecting deviations and allowing actuator corrections to maintain precise wafer placement, and a height sensor 1072, monitoring the wafer height to ensure optimal focus and surface flatness. Optionally, an additional sensor is provided to link the position of the measurement system 1070 to the support 1006, ensuring stable and reliable measurement accuracy.

Alternatively, when the top plate 1024 is transparent to the sensor wavelength, the sensor system 1070 can be positioned stationary on the support 1006. The transparency of the top plate 1024 ensures that the measurement system 1070 is still able to detect the substrate 1001 accurately, even as the top plate 1024 moves in the transverse direction TD. This arrangement eliminates the need for the measurement system 1070 to move along with the top plate 1024, further simplifying the design and reducing the number of moving components.

In an alternative embodiment, the support 1006 is split into two parts: a stationary support part and a movable support part. The movable support part includes the movable top plate, which remains moveable relative to the base 1008 of the recess 1005. The movable support part is configured to move in the transverse direction TD, while the stationary support part provides a fixed reference for the substrate support assembly 1000. The measurement system 1070, e.g. including one or more encoders, is integrated within the movable support part. The measurement system 1070 determines the displacement of the movable support part relative to the stationary support part, providing real-time feedback to ensure precise positioning of the top plate 1024 in accordance with wafer thickness and alignment requirements. The leaf spring mechanism 1060 is used to guide the movement of the movable support part. Instead of the leaf spring mechanism 1060, a linear bearing system can be employed to guide the movement of the movable support part. The linear bearing system is arranged between the stationary support part and the movable support part, facilitating smooth and stable motion along the transverse direction TD.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Other aspects of the invention are set-out as in the following numbered clauses.
1. A substrate support assembly configured to support a substrate, the substrate support assembly comprising:
   a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
   a support configured to clamp the substrate to the support table, wherein the support table is held within a recess provided in the support, the plurality of bottom burls facing a base of the recess,
   an actuator assembly comprising one or more actuators arranged in the recess and configured to move the support table relative to the support in a transverse direction with respect to the support plane.
2. The substrate support assembly of clause 1, wherein the base of the recess comprises holes for at least partially accommodating the plurality of bottom burls.
3. The substrate support assembly of clause 1 or clause 2, wherein the one or more actuators are located between the bottom surface of the support table and the base of the recess.
4. The substrate support assembly of clause 3, wherein the one or more actuators are located near or at an edge of the support table.
5. The substrate support assembly of any of the preceding clauses, wherein the support is configured to generate a vacuum or an electrostatic clamping force to clamp the substrate to the support table.
6. The substrate support assembly of any of the preceding clauses 1-4, wherein the support comprises a low melting point metal and a heat source, wherein the heat source is configured to melt the low melting point metal by supplying heat to fill a gap between the recess and the support table with melted low melting point metal, and to solidify the melted low melting point metal by removing heat to clamp the substrate to the support table.
7. The substrate support assembly of clause 1 or clause 2, wherein the one or more actuators are being
   - located in between the plurality of bottom burls, and wherein the support comprises a plurality of clamp burls arranged at the base of the recess, and wherein each actuator is configured to grip an associated clamp burl and/or to slide along the associated clamp burl, or
   - at least partially arranged in the holes of the base of the recess, wherein each actuator is configured to grip an associated bottom burl and/or to slide along the associated bottom burl,
   to move the support table relative to the support in a transverse direction with respect to the support plane.
8. The substrate support assembly of any of the preceding clauses, further comprising a vacuum seal arranged at or near an edge of the support table for enabling vacuum in a space between the bottom surface of the support table and the base of the recess.
9. The substrate support assembly of any of the preceiding clauses, wherein the actuator assembly comprises one or more piezoelectric actuators, for example one or more inchworm motors or one or more piezo-driven screws.
10. The substrate support assembly of any of the preceding clauses, wherein the substrate support assembly further comprises:
   a measurement system to determine a distance between the support table and the base of the recess, the measurement system being configured to provide a measurment signal representative of the determined distance,
   a controller configured to receive the measurement signal and to control the one or more actuators based on the received measurement signal.
11. A substrate support assembly configured to support a substrate, the substrate support assembly comprising:
   a support table configured to support the substrate in a support plane,
   a support configured to clamp the substrate to the support table, wherein the support table is held within a recess provided in the support
   a rotatable pot hole body facing a base of the recess, the pot hole body comprising outer threads engaging recess threads provided at a wall of the recess,
   an actuator assembly comprising one or more actuators arranged in the recess, wherein the actuator assembly is configured to rotate the pot hole body relative to the recess to move the support table relative to the support in a transverse direction with respect to the support plane.
12. A substrate support assembly of clause 11, wherein the pot hole body is part of the support table.
13. A substrate support assembly of clause 11 or clause 12, wherein the actuator assembly comprises one or more spring pre-loaded actuators, for example one or more piezoelectric actuators such as one or more inchworm motors.
14. A substrate support assembly of any of the clauses 11-13, wherein the support comprises a rotatable feedthrough provided in the base of the recess, the feedthrough comprising one or more channels.
15. A substrate support assembly configured to support a substrate, the substrate support assembly comprising:
   a support table configured to support the substrate in a support plane,
   a support configured to clamp the substrate to the support table, wherein the support table is held within a recess in the support, the support having a moveable top plate being movable relative to a base of the recess,
   an actuator assembly comprising one or more actuators arranged at the support and configured to move the top plate relative to the base of the recess in a transverse direction with respect to the support plane.
16. The substrate support assembly of clause 15, wherein the actuator assembly comprises one or more linear actuators.
17. The substrate support assembly of clause 15 or clause 16, wherein the actuator assembly comprises one or more leaf springs or one or more linear bearings configured to guide the movement of the top plate relative to the base of the recess.
18. The substrate support assembly of any of the clauses 15-17, wherein the top plate is optically transparent to a wavelength of about 193nm.
19. The substrate support assembly of any of the clauses 15-18, further comprising a measurement system configured to determine the position of the top plate relative to the support table.
20. The substrate support assembly of any of the precedings clauses, wherein the support table supports a backside of the substrate, wherein a topside of the substrate is opposite to the backside, wherein the actuator assembly is configured to arrange the topside of the substrate below a top surface of the support or the topside of the substrate flush with the top surface of the support.
21. The substrate support assembly of any of the preceding clauses, wherein a circumferential spacer ring is arranged
   - at or near an edge of the support table in the support plane, or
   - between the support table and wall of the recess.
22. A method for supporting a substrate, the method comprising the steps of:
   - providing a substrate support assembly comprising:
      a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
      a support configured to clamp the substrate to the support table, wherein the support table is held within a recess provided in the support, the plurality of bottom burls facing a base of the recess,
   - moving the support table relative to the support in a transverse direction with respect to the support plane.
23. A method for supporting a substrate, the method comprising the steps of:
   - providing a substrate support assembly comprising:
      a support table configured to support the substrate in a support plane,
      a support configured to clamp the substrate to the support table, wherein the support table is held within a recess provided in the support,
      a rotatable pot hole body facing a base of the recess, the pot hole body comprising outer threads engaging recess threads provided at a wall of the recess,
   - rotating the pot hole body relative to the recess to move the support table relative to the support in a transverse direction with respect to the support plane.
24. A method for supporting a substrate, the method comprising the steps of:
   - providing a substrate support assembly comprising:
      a support table configured to support the substrate in a support plane,
      a support configured to clamp the substrate to the support table, wherein the support table is held within a recess in the support, the support having a moveable top plate being movable relative to a base of the recess,
   - moving the top plate relative to the base of the recess in a transverse direction with respect to the support plane.
25. An exposure apparatus comprising
   a substrate support assembly of any of the clauses 1-21 to support a substrate.

## Claims

1. A substrate support assembly configured to support a substrate, the substrate support assembly comprising:
a support table configured to support the substrate in a support plane, the support table having a top surface facing the substrate and a bottom surface opposite to the top surface, the support plane being parallel to the top surface of the support table, the support table comprising a plurality of bottom burls at the bottom surface,
a support configured to clamp the substrate to the support table, wherein the support table is held within a recess provided in the support, the plurality of bottom burls facing a base of the recess,
an actuator assembly comprising one or more actuators arranged in the recess and configured to move the support table relative to the support in a transverse direction with respect to the support plane.

2. The substrate support assembly of claim 1, wherein the base of the recess comprises holes for at least partially accommodating the plurality of bottom burls.

3. The substrate support assembly of claim 1 or claim 2, wherein the one or more actuators are located between the bottom surface of the support table and the base of the recess.

4. The substrate support assembly of any of the preceding claims, wherein the support is configured to generate a vacuum or an electrostatic clamping force to clamp the substrate to the support table.

5. The substrate support assembly of any of the preceding claims 1 - 4, wherein the support comprises a low melting point metal and a heat source, wherein the heat source is configured to melt the low melting point metal by supplying heat to fill a gap between the recess and the support table with melted low melting point metal, and to solidify the melted low melting point metal by removing heat to clamp the substrate to the support table.

6. The substrate support assembly of claim 1 or claim 2, wherein the one or more actuators are being
a. located in between the plurality of bottom burls, and wherein the support comprises a plurality of clamp burls arranged at the base of the recess, and wherein each actuator is configured to grip an associated clamp burl and/or to slide along the associated clamp burl, or
b. at least partially arranged in the holes of the base of the recess, wherein each actuator is configured to grip an associated bottom burl and/or to slide along the associated bottom burl,
to move the support table relative to the support in a transverse direction with respect to the support plane.

7. The substrate support assembly of any of the preceding claims, wherein the actuator assembly comprises one or more piezoelectric actuators, for example one or more inchworm motors or one or more piezo-driven screws.

8. The substrate support assembly of any of the preceding claims, wherein the substrate support assembly further comprises:
a measurement system to determine a distance between the support table and the base of the recess, the measurement system being configured to provide a measurment signal representative of the determined distance,
a controller configured to receive the measurement signal and to control the one or more actuators based on the received measurement signal.

9. A substrate support assembly configured to support a substrate, the substrate support assembly comprising:
a support table configured to support the substrate in a support plane,
a support configured to clamp the substrate to the support table, wherein the support table is held within a recess provided in the support
a rotatable pot hole body facing a base of the recess, the pot hole body comprising outer threads engaging recess threads provided at a wall of the recess,
an actuator assembly comprising one or more actuators arranged in the recess, wherein the actuator assembly is configured to rotate the pot hole body relative to the recess to move the support table relative to the support in a transverse direction with respect to the support plane.

10. A substrate support assembly of claim 9, wherein the pot hole body is part of the support table.

11. A substrate support assembly configured to support a substrate, the substrate support assembly comprising:
a support table configured to support the substrate in a support plane,
a support configured to clamp the substrate to the support table, wherein the support table is held within a recess in the support, the support having a moveable top plate being movable relative to a base of the recess,
an actuator assembly comprising one or more actuators arranged at the support and configured to move the top plate relative to the base of the recess in a transverse direction with respect to the support plane.

12. The substrate support assembly of claim 11, further comprising a measurement system configured to determine the position of the top plate relative to the support table.

13. The substrate support assembly of any of the precedings claims, wherein the support table supports a backside of the substrate, wherein a topside of the substrate is opposite to the backside, wherein the actuator assembly is configured to arrange the topside of the substrate below a top surface of the support or the topside of the substrate flush with the top surface of the support.

14. The substrate support assembly of any of the preceding claims, wherein a circumferential spacer ring is arranged
a. at or near an edge of the support table in the support plane, or
b. between the support table and wall of the recess.

15. An exposure apparatus comprising
a substrate support assembly of any of the claims 1-14 to support a substrate.
